(19) **Europäisches Patentamt**

**European Patent Office**

**Office européen des brevets**

(11) **EP 0 959 560 B1**

(12) **EUROPEAN PATENT SPECIFICATION**

(45) Date of publication and mention
of the grant of the patent:
**02.02.2005  Bulletin 2005/05**

(51) Int Cl.⁷: $H03F\ 3/45$

(21) Application number: **98830318.6**

(22) Date of filing: **22.05.1998**

(54) **Error amplifier with a high common mode rejection**

Fehlerverstärker mit hoher Gleichtaktunterdrückung

Amplificateur d'erreur avec une grande réjection de mode commun

(84) Designated Contracting States:
**DE FR GB IT**

(43) Date of publication of application:
**24.11.1999  Bulletin 1999/47**

(73) Proprietor: **STMicroelectronics S.r.l.**
**20041 Agrate Brianza (Milano) (IT)**

(72) Inventors:
 • **Milanesi, Andrea**
  **15052 Casalnoceto (IT)**
 • **Poletto, Vanni**
  **15033 Casale Monferrato (IT)**

(74) Representative: **Pellegri, Alberto et al**
**c/o Società Italiana Brevetti S.p.A.**
**Piazza Repubblica, 5**
**21100 Varese (IT)**

(56) References cited:
**EP-A- 0 534 007**   **US-A- 4 641 105**
**US-A- 5 319 265**

**Description**

FIELD OF THE INVENTION

The present invention relates in general to signal processing circuits and more in particular to differential amplifiers.

BACKGROUND OF THE INVENTION

The differential amplifier is a very important analog functional circuit, being able to provide for an output signal (Vout) that correspond to the difference between two input voltages (Va-Vb), multiplied by a certain gain factor, definable in the design stage.

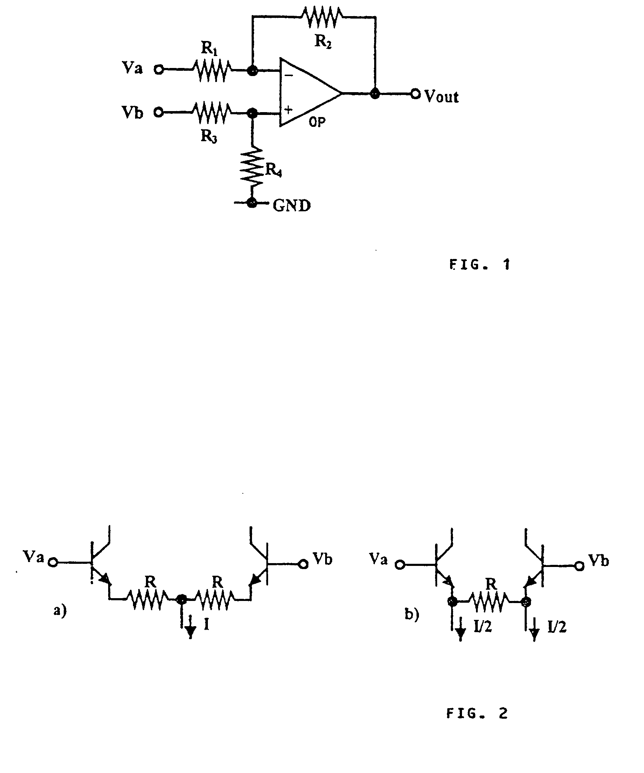

A classical scheme of a differential amplifier is depicted in figure 1.

This circuit is described in any electronics textbook and is generally based on a so-called operational (feedback) amplifier.

The main drawback of the classical differential amplifier of figure 1 is a poor common mode rejection because any spread of the value of the resistances about their nominal design value produces a not null common mode output signal.

A different approach to realize a differential amplifier is based on the use of a degeneration resistance connected between the emitters of an input pair of transistors, according to one or the other of the two circuits shown in figure 2.

Although according to this alternative approach the common mode rejection can be remarkably enhanced, a limit is introduced to the maximum swing of the input voltages, which can no longer reach as far as the power supply voltage.

It is evident the need and/or utility of a differential amplifier capable of ensuring an enhanced common mode rejection without restricting the voltage swing and keep the inputs "compatible" with the power supply voltage.

SUMMARY OF THE INVENTION

The invention provides a differential amplifier with an outstandingly high common mode rejection while maintaining substantially unchanged the inputs dynamic.

Substantially, the circuit of the invention employs a comparator, to the inputs of which are applied the two input signals for outputting a signal whose sign is indicative of the sign of the difference between the two input signals.

The operational amplifier of the basic diagram of the differential amplifier is fedback through a current mirror and the feedback signal is switchingly applied to the non inverting input or to the inverting input of the operational amplifier, depending on the sign of the difference detected by the comparator, thus ensuring in any case a negative feedback.

To this end, in cascade to the output of the operational amplifier, there is also a stage whose function is to invert or not the sign of the output signal of the operational amplifier, depending on the sign information provided by the comparator.

The output signal, whether inverted or not by the dedicated stage placed in cascade to the operational amplifier, drives an output stage consisting of a transistor and a resistive load, the value of which may be designed to define a certain multiplying factor of the difference between the input signals.

The output stage constitutes the input branch of a current mirror that, through a switch, controlled by the output of the comparator, injects a feedback current either on the inverting or on the non inverting input node of the operational amplifier.

BRIEF DESCRIPTION OF THE DRAWINGS

    **Figures 1 and 2** are basic diagrams of known differential amplifiers, as mentioned above.

    **Figure 3** is a basic diagram of the circuit of the invention.

    **Figure 4** shows an alternative embodiment of the differential amplifier of the invention.

DESCRIPTION OF EMBODIMENTS OF THE INVENTION

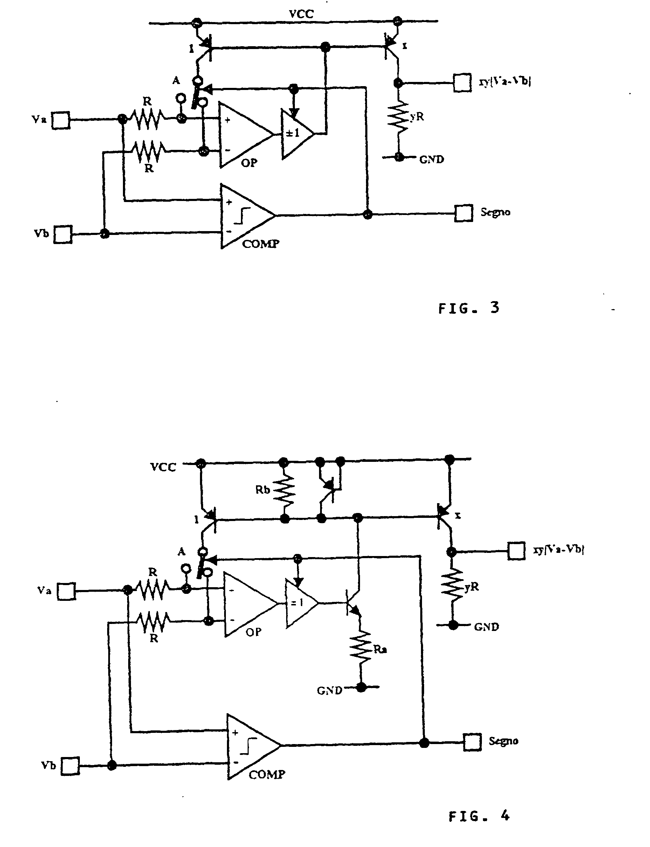

By referring to figure 3, the basic circuit diagram, of the differential amplifier of the invention comprises a common operational amplifier, OP, on the inverting (-) and on the noninverting (+) inputs of which are applied, through two input resistances of identical value, R, the input signals: Va and Vb, respectively. The output of the operational amplifier drives, after inversion or not, an output stage that in the represented example is constituted by a bipolar junction transistor, x, (a PNP transistor in the example) and by a resistive load, yR.

The block $\pm 1$, coupled in cascade to the output of the operational amplifier OP, has the function of inverting or not the signal output by the operational amplifier OP, depending on the sign of the difference: Va-Vb.

This sign information is provided by a dedicated zero-cross comparator (COMP), to the inputs (+, -) of which are applied the input voltages Va and Vb, respectively.

The transistor x of the output stage of the differential amplifier of the invention constitutes the input branch of a current mirror that comprises a second bipolar junction PNP transistor, 1.

The signal representing the sign of the difference between the input signals: Va-Vb, output by the comparator COMP, besides determining or not the inversion of the signal output by the operational amplifier OP, through the dedicated stage ±1, controls the switch A that selects either the inverting (-) or the noninverting (+) input node into which injecting the feedback current, forced by the transistor 1 of the current mirror composed by the transistors, 1 and x.

By switching on one or the other input of the operational amplifier OP the feedback current and by inverting or not inverting the signal output by the operational amplifier OP the coherency of the sign of the signals and an always negative feedback of the operational amplifier are assured under any circumstance.

The common mode gain of the circuit of the invention is practically null.

In fact, the operational amplifier OP regulates the current through the two branches of the current mirror formed by the transistors x and 1 so that its inverting (-) and noninverting (+) inputs be at the same voltage and the entire circuit functions in a linear mode.

Accordingly, when Va and Vb are different, through one of the two input resistances (R) there will not flow any current, while the voltage difference |Va-Vb| will be applied across the other input resistance. However, the current flowing through the so biased input resistance is mirrored on the load resistance yR of the output stage, multiplied by an x factor that corresponds to the current gain of the homonymous PNP transistor of the output stage.

By assuming that the load resistance of the output stage is y times the input resistance R, the output voltage Vout is then given by:

$$Vout = xy \, |Va\text{-}Vb|$$

When Va and Vb are at the same voltage, it is evident that no current can flow in the input resistances R, therefore, the output of the circuit will be null (Vout=0).

Any instability at high frequency of the circuit of the invention of figure 3 may be prevented by using a modified circuit as shown in figure 4.

According to this preferred embodiment of the circuit of the invention, it is possible to regulate the loop gain of the circuit. To this purpose use is made of a dedicated intermediate amplifying stage, constituted by a third NPN transistor 2 and by the load resistance Ra, for driving the transistor x of the output stage, as well as of the feedback current mirror.

The loop gain will be determined by the Ra/R ratio and in order to ensure stability it will be preferable to design it to be sufficiently greater than 1.

The resistance Rb and the diode D are used to maintain the transistor 2 always in an active region of its characteristic even when the input voltage difference (Va-Vb) is null.

The circuit of the differential amplifier of the invention is useful in innumerable applications, every time an exceptionally high common mode rejection is required.

**Claims**

1. A differential amplifier comprising an operational amplifier (OP), a first inverting input resistance (R) and a second noninverting input resistance (R), and negative feedback means, **characterized in that** it also comprises:

   - a comparator (COMP) having inputs coupled to the inputs of the operational amplifier and an output onto which a signal representative of the sign of the difference (Va-Vb) between the signals applied to said inputs is produced;

   - said means of negative feedback including at least an output stage composed by a first transistor (x) and by a resistive load (yR), driven by the signal output by said operational amplifier (OP), said first transistor (x) constituting a feedback current mirror with at least a second transistor (1);

   - a switch (A) controlled by the output of said comparator, switching a feedback current of said current mirror (1, x) on the noninverting input node (+) or on the inverting input node (-) of said operational amplifier (OP);

   - a switchingly configured inverting or non inverting stage (±1), controlled by the output of said comparator (COMP), having an input coupled to the output of said operational amplifier (OP) and an output coupled to the driving node of said first transistor (x) of the output stage; the control of said switch (A) and of said inverting or non inverting stage (±1) by the output of said comparator (COMP) maintaining a negative feedback on said operational amplifier (OP).

2. The differential amplifier according to claim 1, **characterized in that** said first and second transistors (1, x) constituting the feedback current mirror are PNP transistors.

3. The differential amplifier according to claim 2, **characterized in that** it comprises further

   - an intermediate gain stage consisting of a third NPN transistor (2) and a load resistance (Ra), operatively coupled between the output of said inverting or non inverting stage (±1) and the driving node of said first transistor (x) of said output stage, and a biasing resistance (Rb) and a diode (D), connected in parallel, between said driving node and the power supply node, wherein the ratio between the value of said load resistance (Ra) and of said input resistances (R) is greater than one.

## Patentansprüche

1. Differenzverstärker mit einem Operationsverstärker (OP), einem ersten invertierenden Eingangswiderstand (R) und einem zweiten nichtinvertierenden Eingangswiderstand (R), und einer Gegenkopplungseinrichtung, **dadurch gekennzeichnet, daß** er außerdem aufweist:

   - einen Komparator (COMP), der Eingänge, die an die Eingänge des Operationsverstärkers gekoppelt sind, und einen Ausgang aufweist, an dem ein Signal erzeugt wird, das für das Vorzeichen der Differenz (Va-Vb) zwischen den Signalen repräsentativ ist, die an die Eingänge angelegt werden;
   - wobei die Gegenkopplungseinrichtung mindestens eine Ausgangsstufe aufweist, die aus einem ersten Transistor (x) und aus einer ohmschen Belastung (yR) besteht, die durch das Signal betrieben wird, das durch den Operationsverstärker (OP) ausgegeben wird, wobei der erste Transistor (x) mit mindestens einem zweiten Transistor (1) einen Rückkopplungsstromspiegel bildet;
   - einen Schalter (A), der durch den Ausgang des Komparators gesteuert wird, der einen Rückkopplungsstrom des Stromspiegels (1, x) an den nichtinvertierenden Eingangsknoten (+) oder an den invertierenden Eingangsknoten (-) des Operationsverstärkers (OP) schaltet;
   - eine schaltend konfigurierte invertierende oder nichtinvertierende Stufe (±1), die durch den Ausgang des Komparators (COMP) gesteuert wird, die einen Eingang, der mit dem Ausgang des Operationsverstärkers (OP) gekoppelt ist, und einen Ausgang aufweist, der mit dem Treiberknoten des ersten Transistors (x) der Ausgangsstufe gekoppelt ist;

   wobei die Steuerung des Schalters (A) und der invertierenden oder nichtinvertierenden Stufe (±1) durch den Ausgang des Komparators (COMP) eine Gegenkopplung am Operationsverstärker (OP) aufrechterhält.

2. Differenzverstärker nach Anspruch 1, **dadurch gekennzeichnet, daß** die ersten und zweiten Transistoren (1, x), die den Rückkopplungsstromspiegel bilden, PNP-Transistoren sind.

3. Differenzverstärker nach Anspruch 2, **dadurch gekennzeichnet, daß** er ferner aufweist

   - eine Zwischenverstärkungsstufe, die aus einem dritten NPN-Transistor (2) und einem Lastwiderstand (Ra) besteht, die betriebsfähig zwischen den Ausgang der invertierenden oder nichtinvertierenden Stufe (±1) und den Steuerknoten des ersten Transistors (x) der Ausgangsstufe gekoppelt ist, und einen Vorspannwiderstand (Rb) und eine Diode (D), die zwischen dem Steuerknoten und dem Stromversorgungsknoten parallelgeschaltet sind,

   wobei das Verhältnis zwischen dem Wert des Lastwiderstands (Ra) und der Eingangswiderstände (R) größer als eins ist.

## Revendications

1. Amplificateur différentiel comprenant un amplificateur opérationnel (OP), une première résistance d'entrée inverseuse (R) et une seconde résistance d'entrée non inverseuse (R), et un moyen de contreréaction, **caractérisé en ce qu'**il comprend en outre :

   un comparateur (COMP) ayant des entrées couplées aux entrées de l'amplificateur opérationnel et une sortie sur laquelle un signal représentatif du signe de la différence (Va-Vb) entre les signaux appliqués aux entrées est produit ;
   le moyen de contre-réaction comprenant au moins un étage de sortie constitué d'un premier transistor (x) et d'une charge résistive (yR), pilotée par la sortie de signal de l'amplificateur opérationnel (OP), le premier transistor (x) constituant un miroir de courant à réaction avec au moins un second transistor (1) ;
   un commutateur (A) commandé par la sortie du comparateur, commutant un courant de réaction du miroir de courant (1, x) sur le noeud d'entrée non inverseur (+) ou sur le noeud d'entrée inverseur (-) de l'amplificateur opérationnel (OP) ;
   un étage configuré en commutation de façon inverseuse ou non inverseuse (±1), commandé par la sortie du comparateur (COMP), ayant une entrée couplée à la sortie de l'amplificateur opérationnel (OP) et une sortie couplée au noeud du pilotage du premier transistor (x) de l'étage de sortie ;
   la commande du commutateur (A) et de l'étage inverseur ou non inverseur (±1) par la sortie du comparateur (COMP) maintenant une contreréaction sur l'amplificateur opérationnel (OP).

2. Amplificateur différentiel selon la revendication 1, **caractérisé en ce que** les premier et second transistors (1, x) constituant le miroir de courant à réaction sont des transistors PNP.

3. Amplificateur différentiel selon la revendication 2, **caractérisé en ce qu'**il comprend en outre un étage de gain intermédiaire comprenant un troisième transistor NPN (2) et une résistance de charge (Ra) couplée opérativement entre la sortie de l'étage inverseur ou non inverseur (±1) et le noeud de pilotage du premier transistor (x) de l'étage de sortie, et une résistance de polarisation (Rb) et une diode (D), connectées en parallèle entre le noeud de pilotage et le noeud d'alimentation, dans lequel le rapport entre la valeur de la résistance de charge (Ra) et des résistances d'entrée (R) est supérieur à un.

5

FIG. 1

FIG. 2

FIG. 3

FIG. 4